# EUROPÄISCHE PATENTANMELDUNG

(11) **EP 1 870 934 A1**
(43) Veröffentlichungstag der Anmeldung: **26.12.2007**
(21) Anmeldenummer: 07008818.2
(22) Anmeldetag: 02.05.2007
(51) Int. Cl.: H01L 25/07, H01L 23/40, H05K 7/20

(54) **Stromrichtermodul**

(30) Priorität: 01.06.2006 DE 102006025531
(71) Anmelder: Semikron Elektronik GmbH & Co. KG Patentabteilung, 90431 Nürnberg (DE)
(72) Erfinder: Heilbronner, Heinrich, Dr., 90547 Stein (DE)

(57) **Zusammenfassung**

Es wird ein Stromrichtermodul (64) mit Leistungshalbleiterchips (10, 12) beschrieben, die auf einer ersten Seite (18) eine erste Kontaktfläche (20) und auf der gegenüberliegenden zweiten Seite (22) eine zweite Kontaktfläche (24) und gegebenenfalls ein Gate (26) aufweisen. Die ersten Kontaktflächen (20) sind jeweils mit einem Kühlkörper (28, 30) verbunden. An der zweiten Seite (22) der Leistungshalbleiterchips ist eine Leiterplatte (36) vorgesehen, die zur Kontaktierung der zweiten Kontaktflächen (24) und der Gates (26) dient. An der Leiterplatte (36) sind die Treiberelektronikbauelemente (38) für die Gates (26) vorgesehen. Die Leiterplatte (36) und die Leistungshalbleiterchips (10, 12, 14, 16) werden zur schaltungsgemäßen Kontaktierung mittels einer Drückeinrichtung (40) gegen die Kühlkörper (28, 30) gepresst.

## Beschreibung

Die Erfindung betrifft ein Stromrichtermodul.

Ein solches Stromrichtermodul ist beispielsweise aus der DE 101 21 970 A1 bekannt. Dieses bekannte Modul weist ein Gehäuse, ein keramisches Substrat, darauf schaltungsgerecht angeordnete strukturierte und elektrisch leitende Kontaktflächen, darauf angeordnete Bauelemente in Gestalt von Leistungshalbleiterchips, eine Drückeinrichtung, bestehend aus einem flexiblen Druckspeicher sowie einer den Druck erzeugenden Druckplatte, sowie Leistungs- und Steueranschlüsse auf. Dabei dient eine Leiterplatte zum schaltungsgerechten Verbinden der Bauelemente miteinander und/oder mit den Kontaktflächen des Substrates, wobei zur Isolation der Bauelemente gegeneinander ein flexibler Isolationsstoff vorgesehen ist. Bei den Bauelementen in Gestalt von Leistungshalbleiterchips handelt es sich um IGBTs (insulated gate bipolar transistors) und um FLDs (Freilaufdioden).

Die DE 102 58 565 B3 offenbart eine Schaltungsanordnung zur Kontaktierung von Halbleiterbauelementen, insbesondere Leistungshalbleiterbauelemente, miteinander und/oder mit zugeordneten Anschlussleitern, wobei die Schaltungsanordnung aus mindestens zwei Anschlussleitern, mindestens zwei Halbleiterbauelementen sowie mindestens einem Isollerstoffkörper besteht. An dem ersten Anschlussleiter ist der Isolierstoffkörper angeordnet, der eine Anzahl Durchkontaktierungen aufweist, die aus mit einem elektrisch sowie thermisch leitfähigen Werkstoff verfüllten Durchbrüchen bestehen. An der zweiten Seite des Isolierstoffkörpers ist mindestens eines der Halbleiterbauelemente angeordnet, wobei mindestens eine Kontaktfläche mittels der Durchkontaktierung des Isolierstoffkörpers mit dem ersten Anschlussleiter verbunden ist.

Die DE 41 32 947 A1 beschreibt eine elektronische Schaltungsanordnung, wobei es durch den Einsatz von wärmeleitenden, elektrisch isolierenden und/oder elektrisch leitenden Pasten sowie von flexiblen Leiterplatten möglich ist, die Packungsdichte von in die Schaltungsanordnung integrierten Bauteilen bzw. Bauelementen zu erhöhen, die Verbindungstechnik zu rationalisieren und die Kontaktierung zu optimieren. Dabei gestattet die wirtschaftliche Fertigung, verbunden mit einer zerstörungsfreien partiellen Demontagemöglichkeit, bei Verwendung von Pasten und Folien den weitergehenden Zusammenbau elektronischer Schaltungsanordnungen mit einem umfangreicheren Schaltungsinhalt in der Schaltungseinheit.

Der Erfindung liegt die Aufgabe zugrunde, ein Stromrichtermodul zu schaffen, das bei einem minimalen Bauvolumen eine hohe Leistungsdichte und Zuverlässigkeit aufweist.

Diese Aufgabe wird erfindungsgemäß durch die Merkmale des Anspruches 1 gelöst. Bevorzugte Aus- bzw. Weiterbildungen des erfindungsgemäßen Stromrichtermoduls sind in den Unteransprüchen gekennzeichnet.

Das erfindungsgemäße Stromrichtermodul weist den Vorteil auf, dass große innere Wärmewiderstände in dem Stromrichtermodul vermieden werden, weil keine Löt- und/oder Bondverbindungen zwischen den Leistungshalbleiterchips und/oder den Kühlkörpern vorhanden sind. Durch die Vermeidung von Löt- und/oder Bondverbindungen sind in vorteilhafter Weise hohe Junctiontemperaturen beherrschbar. Ein weiterer Vorteil des erfindungsgemäßen Stromrichtermoduls besteht darin, dass durch die Integration der Leistungshalbleiterchips, ihren Ansteuerungen und den Kühlkörpern kleinvolumige, d.h. kompakte System realisierbar sind, die mittels Druckkontakt und Folienleiter der Leiterplatte sowohl elektrisch als auch thermisch optimal verbunden sind.

Die Vermeidung von Löt- und/oder Bondverbindungen und die Vermeidung von Isolationsschichten führen in vorteilhafter Weise zu einem optimalen Leistungs-/ Volumen-Verhältnis des erfindungsgemäßen Stromrichtermoduls bei einer gleichzeitigen Steigerung seiner Betriebszuverlässigkeit.

Weitere Einzelheiten, Merkmale und Vorteile ergeben sich aus der nachfolgenden Beschreibung von in der Zeichnung schematisch verdeutlichten Ausbildungen des erfindungsgemäßen Stromrichtermoduls.

Es zeigen:
- Figur 1: eine Schaltdiagrammdarstellung einer Ausbildung des Stromrichtermoduls als Halbbrücke,
- Figur 2: schematisch und nicht maßstabgetreu eine Schnittdarstellung der Halbbrücke gemäß Figur 1,
- Figur 3: eine der Figur 1 ähnliche Schaltdiagrammdarstellung einer Ausbildung des Stromrichtermoduls als Dreiphasenbrücke, und
- Figur 4: eine schematische Draufsicht auf die Dreiphasenbrücke gemäß Figur 3.

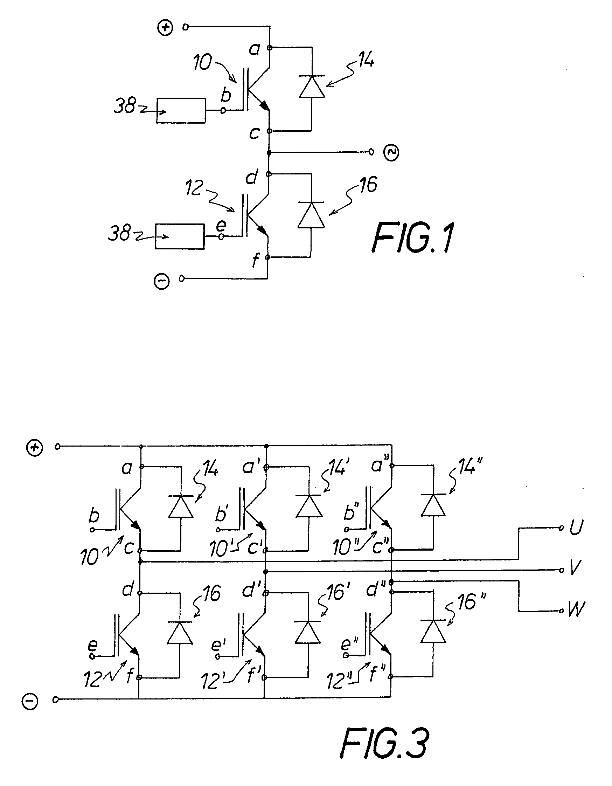

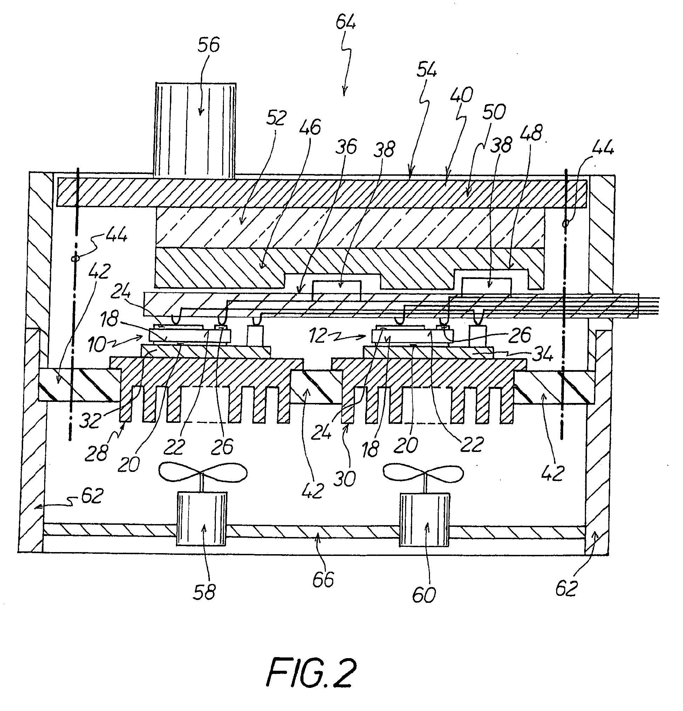

Figur 1 verdeutlicht eine Halbbrücke mit Leistungshalbleiterchips in Gestalt von IGBTs 10 und 12 und zu diesen parallel geschalteten FLDs 14, 16. In Figur 2 sind nur die IGBTs 10 und 12 verdeutlicht. Das jeweilige Leistungshalbleiterchip 10, 12 weist in an sich bekannter Weise auf einer Seite 18 eine erste Kontaktfläche 20 und auf der gegenüberliegenden zweiten Seite 22 eine zweite Kontaktfläche 24 und ein Gate 26 auf.

In Figur 1 ist die erste Kontaktfläche 20 des Leistungshalbleiterchips 10 mit a, das Gate 26 mit b und die zweite Kontaktfläche 24 mit c und die erste Kontaktfläche 20 des zweiten Leistungshalbleiterchips 12 mit d, das Gate 26 mit e und die zweite Kontaktfläche 24 mit f bezeichnet.

Die ersten Kontaktflächen 20 der Leistungshalbleiterchips 10 und 12 sind jeweils mit einem zugehörigen Kühlkörper 28, 30 verbunden. Zur mindestens annähernden Kompensation der unterschiedlichen Wärmeausdehnungen des jeweiligen Leistungshalbleiterchips 10, 12 und dem zugehörigen Kühlkörper 28, 30 ist zwischen dem jeweiligen Leistungshalbleiterchip 10, 12 und dem zugehörigen Kühlkörper 28, 30 jeweils ein Molybdänplättchen 32, 34 vorgesehen.

An der von den Kühlkörpern 28, 30 abgewandten zweiten Seite 22 der Leistungshalbleiterchips 10, 12 ist eine Leiterplatte 36 vorgesehen, die zur Kontaktierung der Leistungshalbleiterchips 10, 12, 14, 16 (siehe Figur 1) untereinander und/oder zur Kontaktierung mit den Kühlkörpern 28, 30 dienen. Zu diesem Zwecke ist die Leiterplatte 36 vorzugsweise als flexible Leiterplatte mindestens einlagig, vorzugsweise jedoch mehrlagig ausgebildet.

An der Leiterplatte 36 sind die Treiberelektronikbauelemente 38 für die Gates 26 der IGBTs 10, 12 vorgesehen.

Zur schaltungsgemäßen Kontaktierung der Leistungshalbleiterchips 10, 12, 14, 16 miteinander und mit den zugehörigen Kühlkörpern 28, 30 mittels der vorzugsweise flexiblen Leiterplatte 36 ist eine Drückeinrichtung 40 vorgesehen, die direkt und unmittelbar mit den Kühlkörpern 28, 30 fest verbindbar ist, oder die mit einem Isolierrahmen 42 fest verbindbar ist, der die Kühlkörper 28, 30 voneinander beabstandet und gegeneinander elektrisch isoliert.

Die feste Verbindung der Drückeinrichtung 40 mit den Kühlkörpern 28, 30 oder vorzugsweise mit dem Isolierrahmen 42 erfolgt mit Hilfe von Schrauben 44, die in Figur 2 nur schematisch durch strichlierte Linien angedeutet sind.

Dienen die Schrauben 44 zur festen Verbindung der Drückeinrichtung 40 mit den Kühlkörpern 28, 30, so müssen die Schrauben 44 selbstverständlich elektrisch isoliert sein. Ist die Drückeinrichtung 40 mit Hilfe der Schrauben 44 mit dem Isolierrahmen 42 fest verbunden, so brauchen die Schrauben 44 in vorteilhafter Weise nicht elektrisch isoliert zu sein.

Die Drückeinrichtung 40 weist ein Brückenelement 46 mit einer passend strukturierten Oberfläche 48 auf, um die Leistungshalbleiterchips 10, 12, 14, 16 mit den entsprechenden Kontaktstellen der Leiterplatte 36 zuverlässig zu kontaktieren.

Diese Kontaktstellen sind beispielsweise noppenförmig ausgebildet und in Figur 2 - der Schaltung gemäß Figur 1 entsprechend - mit a, b, c, d, e und f bezeichnet.

Die Drückeinrichtung 40 weist außerdem eine formstabile Druckplatte 50 und einen flexiblen Druckspeicher 52 auf, der zwischen der formstabilen Druckplatte 50 und dem Brückenelement 46 vorgesehen ist. Die Drückeinrichtung 40 bildet eine Montageplattform 54, an der weitere Subsysteme 56 vorgesehen sein können. Bei diesen Subsystemen 56 kann es sich beispielsweise um Zwischenkreiskondensatoren, Filter oder dergleichen handeln.

Den Kühlkörpern 28, 30 sind Lüftergebläse 58, 60 zugeordnet, die in einem Gehäuse 62 des Stromrichtermoduls 64 vorgesehen sind. Die Befestigung der Lüftergebläse 58, 60 im Gehäuse 62 erfolgt mit Hilfe von Befestigungselementen 66, die die Luftströmung in das Gehäuse 62 hinein nicht beeinträchtigen.

Die Leiterplatte 36 weist die Außenanschlüsse des Stromrichtermoduls 64 auf. Diese Außenanschlüsse sind - wie in Figur 1 - mit +, - und dem Wechselanschluss bezeichnet. Dabei handelt es sich um die Lastanschlüsse. Außerdem sind Steueranschlüsse für die Treiberelektronikbauelemente 38 vorgesehen.

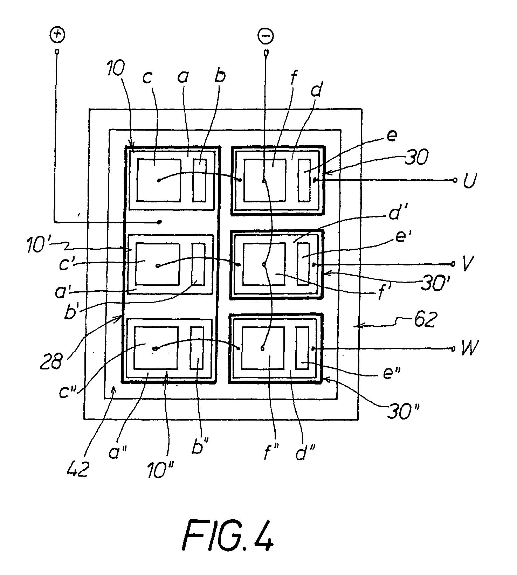

Figur 3 verdeutlicht in einer der Figur 1 ähnlichen Schaltdiagrammdarstellung eine Dreiphasenbrücke, wobei gleiche Einzelheiten mit denselben Bezugsziffern wie in Figur 1 bezeichnet sind, so dass es sich erübrigt, in Verbindung mit Figur 3 alle diese Einzelheiten noch einmal detailliert zu beschreiben.

Die Figur 4 verdeutlicht in einer Ansicht von oben schematisch eine Ausbildung des Stromrichtermoduls 64 der Dreiphasenbrücke gemäß Figur 3. Aus Figur 4 ist ersichtlich, dass die ersten Kontaktflächen der Anschlüsse a, a' und a" der IGBTs 10, 10' und 10" an einem gemeinsamen Kühlkörper 28 vorgesehen sind, während die gegenüberliegenden zweiten Kontaktflächen 24 (siehe Figur 2), welchen die Wechselspannungsanschlüsse U, V und W zugeordnet sind, jeweils dem Anschluss d, d' und d" entsprechend an einem eigenen Kühlkörper 30, 30' und 30" vorgesehen sind.

Mit der Bezugsziffer 42 ist auch in Figur 4 ein Isolierrahmen bezeichnet, in welchem die Kühlkörper 28, 30, 30' und 30" voneinander beabstandet und gegeneinander elektrisch isoliert festgelegt sind. Mit der Bezugsziffer 62 ist das Gehäuse des Stromrichtermoduls 64 bezeichnet.

Gleiche Einzelheiten sind in den Figuren 1 bis 4 jeweils mit denselben Bezugsziffern bezeichnet, so dass es sich erübrigt, in Verbindung mit allen Figuren alle Einzelheiten jeweils detailliert zu beschreiben.

### Bezugsziffernliste:

- 10: IGBT
- 12: IGBT
- 14: FLD
- 16: FLD
- 18: erste Seite (von 10, 12)
- 20: erste Kontaktfläche (an 18)
- 22: zweite Seite (von 10, 12)
- 24: zweite Kontaktfläche (an 22)
- 26: Gate (von 10, 12 an 22)
- 28: Kühlkörper (für 10, 14)
- 30: Kühlkörper (für 12, 16)
- 32: Molybdänplättchen (zwischen 10 und 28)
- 34: Molybdänplättchen (zwischen 12 und 30)
- 36: Leiterplatte (für 10, 12, 14, 16)
- 38: Treiberelektronikbauelemente (für 26)
- 40: Drückeinrichtung (von 64)
- 42: Isolierrahmen (für 28, 30)
- 44: Schrauben (zwischen 40 und 42 oder zwischen 40 und 28, 30)
- 46: Brückenelement (von 40)
- 48: Oberfläche (von 46)
- 50: Druckplatte (von 40)
- 52: flexibler Druckspeicher (von 40 zwischen 50 und 46)
- 54: Montageplattform (von 40 für 56)
- 56: Subsystem (an 54)
- 58: Lüftergebläse (für 28)
- 60: Lüftergebläse (für 30)
- 62: Gehäuse (von 64)
- 64: Stromrichtermodul
- 66: Befestigungselemente (von 62 für 58, 60)

## Patentansprüche

1. Stromrichtermodul mit mindestens einem Paar Leistungshalbleiterchips (10, 12), die auf einer ersten Seite (18) eine erste Kontaktfläche (20) und auf der gegenüberliegenden zweiten Seite (22) eine zweite Kontaktfläche (24) und ein Gate (26) aufweisen, wobei die ersten Kontaktflächen (20) jeweils mit einem Kühlkörper (28, 30) verbunden sind, und an der zweiten Seite (22) eine Leiterplatte (36) zur Kontaktierung der zweiten Kontaktflächen (24) und der Gates (26) vorgesehen ist, wobei an der Leiterplatte (36) die Treiberelektronikbauelemente (38) für die Gates (26) vorgesehen sind, und wobei die Leiterplatte (36) und die Leistungshalbleiterchips (10, 12, 14, 16) zur schaltungsgemäßen Kontaktierung mittels einer Drückeinrichtung (40) gegen die Kühlkörper (28, 30) gepresst werden.

2. Stromrichtermodul nach Anspruch 1,
**dadurch gekennzeichnet,**
**dass** das jeweilige Leistungshalbleiterchip (10, 12, 14, 16) mit seiner ersten Kontaktfläche (20) an einem Molybdänplättchen (32, 34) vorgesehen ist.

3. Stromrichtermodul nach Anspruch 1,
**dadurch gekennzeichnet,**
**dass** die Leiterplatte (36) als flexible, mehrlagige Leiterplatte ausgebildet ist.

4. Stromrichtermodul nach Anspruch 1,
**dadurch gekennzeichnet,**
**dass** die Drückeinrichtung (40) ein oberflächenstrukturiertes Brückenelement (46) aufweist, das zur Kontaktierung der Leistungshalbleiterchips (10, 12, 14, 16) an der Leiterplatte (36) vorgesehen ist.

5. Stromrichtermodul nach Anspruch 1,
**dadurch gekennzeichnet,**
**dass** die Drückeinrichtung (40) einen flexiblen Druckspeicher (52) und eine formstabile Druckplatte (50) aufweist.

6. Stromrichtermodul nach einem der Ansprüche 1 bis 5,
**dadurch gekennzeichnet,**
**dass** die eine Montageplattform (54) bildende Drückeinrichtung (40) mit den Kühlkörpern (28, 30) fest verbunden ist.

7. Stromrichtermodul nach Anspruch 6,
**dadurch gekennzeichnet,**
**dass** zur festen Verbindung der Montageplattform (54) mit den Kühlkörpern (28, 30) Schrauben (44) vorgesehen sind.

8. Stromrichtermodul nach Anspruch 6,
**dadurch gekennzeichnet,**
**dass** an der Montageplattform (54) weitere Subsysteme (56) vorgesehen sind.

9. Stromrichtermodul nach einem der Ansprüche 1 bis 8,
**dadurch gekennzeichnet,**
**dass** die Kühlkörper (28, 30) durch einen Isolierrahmen (42) voneinander beabstandet und gegeneinander isoliert sind.

10. Stromrichtermodul nach einem der Ansprüche 1 bis 9,
**dadurch gekennzeichnet,**
**dass** die flexible Leiterplatte (36) die Außenanschlüsse des Stromrichtermoduls (64) aufweist.
